# EUROPEAN PATENT APPLICATION

(11) **EP 4 290 985 A1**
(43) Date of publication of application: **13.12.2023**
(21) Application number: 22750079.0
(22) Date of filing: 07.02.2022
(51) Int. Cl.: H05K 1/02, H05K 1/11, H01L 23/538, H01L 23/367

(54) **SEMICONDUCTOR PACKAGE**

(30) Priority: 05.02.2021 KR 20210016445
(71) Applicant: LG Innotek Co., Ltd., Seoul 07796 (KR)
(72) Inventor: LEE, Jin Hak, Seoul 07796 (KR); SEONG, Dae Hyeon, Seoul 07796 (KR); SHIN, Ga Hui, Seoul 07796 (KR)
(74) Representative: Plasseraud IP
(86) International application number: PCT/KR2022/001849
(87) International publication number: WO 2022/169330

(57) **Abstract**

A semiconductor package according to an embodiment includes a first insulating layer; a first pad disposed on a first surface of the first insulating layer; a second pad disposed on a second surface of the first insulating layer opposite to the first surface; and a first through part passing through the first insulating layer, wherein the first through part comprises a first-first through electrode disposed in a first region of the first insulating layer; and a first-second through electrode disposed in a second region of the first insulating layer, wherein the second region is adjacent to an outer side surface of the first insulating layer, wherein an outer side surface of the first-second through electrode is positioned on the same plane as the outer side surface of the first insulating layer, and wherein the first pad extends from the first region of the first insulating layer to the second region to connect the first-first through electrode and the first-second through electrode.

## Description

### [Technical Field]

An embodiment relates to a semiconductor package.

### [Background Art]

A line width of circuits is becoming smaller as the miniaturization, weight reduction, and integration of electronic components accelerate. In particular, as design rules of semiconductor chips are integrated on a nanometer scale, a circuit line width of a package substrate or a circuit board on which a semiconductor chip is mounted is reduced to several micrometers or less.

In order to increase the degree of circuit integration of the circuit board, that is, various methods have been proposed in order to miniaturize the circuit line width. In order to prevent loss of circuit line width in the etching step to form a pattern after copper plating, a semi-additive process (SAP) method and a modified semi-additive process (MSAP) have been proposed.

Since then, in order to realize a finer circuit pattern, an Embedded Trace Substrate (hereinafter referred to as 'ETS') method, which buries and embeds copper foil in an insulating layer, has been used in this technology field. The ETS method is manufactured by embedding the copper foil circuit in the insulating layer instead of forming it on the surface of the insulating layer. For this reason, there is no circuit loss due to etching, so it is advantageous to refine the circuit pitch.

Meanwhile, recently, efforts are being made to develop an improved 5th generation (5G) communication system or a pre-5G communication system in order to meet the demand for wireless data traffic. Here, the 5G communication system uses ultra-high frequency (mmWave) bands (sub 6 gigabytes (6GHz), 28 gigabytes 28GHz, 35 gigabytes 35GHz or higher frequencies) to achieve high data rates.

And, in order to alleviate the path loss of radio waves in the very high frequency band and increase the propagation distance of radio waves, aggregation technologies such as beamforming, massive MIMO, and array antenna are being developed in the 5G communication system. Various chips constituting the AP module are mounted on the circuit board applied to the communication system of 5G or higher (6G, 7G ~ etc.), and the circuit board includes pads for mounting these chips. In addition, the performance of the 5G or higher communication system may be determined according to characteristics of a chip mounted on the circuit board. In addition, performance improvement of a final product may be determined by the performance of the mounted chip. At this time, the performance of the mounted chip has a close relationship with the heat dissipation performance of the circuit board. For example, the performance of the chip may be determined by the heat dissipation performance of the circuit board, and performance improvement of a final product may be determined according to the performance of the chip.

On the other hand, as described above, there is a demand for a circuit board having a structure capable of improving heat dissipation performance of the circuit board and further, heat dissipation performance of a package substrate in which a chip is mounted on the circuit board.

### [Disclosure]

### [Technical Problem]

The embodiment provides a circuit board having a new structure and a semiconductor package including the circuit board.

Specifically, the embodiment provides a circuit board and a semiconductor package including the circuit board to improve heat dissipation performance by spreading heat generated from a chip in a board or package.

In addition, the embodiment provides a circuit board and a semiconductor package including the circuit board to improve heat dissipation performance by dispersing heat generated from a chip in a plurality of directions.

Technical problems to be solved by the proposed embodiments are not limited to the above-mentioned technical problems, and other technical problems not mentioned may be clearly understood by those skilled in the art to which the embodiments proposed from the following descriptions belong.

### [Technical Solution]

A semiconductor package according to an embodiment comprises a first insulating layer; a first pad disposed on a first surface of the first insulating layer; a second pad disposed on a second surface of the first insulating layer opposite to the first surface; and a first through part passing through the first insulating layer, wherein the first through part comprises a first-first through electrode disposed in a first region of the first insulating layer; and a first-second through electrode disposed in a second region of the first insulating layer, wherein the second region is adjacent to an outer side surface of the first insulating layer, wherein an outer side surface of the first-second through electrode is positioned on the same plane as the outer side surface of the first insulating layer, and wherein the first pad extends from the first region of the first insulating layer to the second region to connect the first-first through electrode and the first-second through electrode.

In addition, a width of the first-second through electrode has a range of 0.3 times and 2 times a width of the first-first through electrode.

In addition, one first pad connects between an upper surface of the first-first through electrode and an upper surface of the first-second through electrode, and wherein the second pad comprises a second-first pad disposed in the first region of the first insulating layer and connected to a lower surface of the first-first through electrode; and a second-second pad disposed in the second region of the first insulating layer and connected to a lower surface of the first-second through electrode.

In addition, an outer side surface of the first pad, an outer side surface of the second-second pad, the outer side surface of the first-second through electrode, and the outer side surface of the first insulating layer are positioned on the same plane.

In addition, the first-first through electrode has a shape different from a shape of the first-second through electrode.

In addition, the outer side surface of the first-second through electrode is perpendicular to the first surface of the first insulating layer.

In addition, an inner side surface of the first-second through electrode has an inclination with respect to the first surface of the first insulating layer.

In addition, at least one of the first-first through electrode and the first-second through electrode has a bar shape extending in a longitudinal direction.

In addition, the first-second through electrode includes a plurality of sub through electrodes including an outer side surface respectively positioned on the same plane as the outer side surface of the first insulating layer and spaced apart from each other.

In addition, the first-second through electrode includes a connection through electrode connecting the plurality of sub through electrodes, and wherein a planar shape of the first-second through electrode has a U-shape.

### [Advantageous Effects]

The embodiment includes an outer through electrode exposed to an outer side surface of the circuit board. Accordingly, the embodiment may allow heat generated through the chip to be transferred to a side surface of the circuit board through the outer through electrode, thereby improving the heat dissipation performance of the circuit board.

In addition, the embodiment may allow at least one insulating layer among the plurality of insulating layers not to be provided with an outer through electrode. For example, an plurality of outer through electrodes included in the circuit board are divided into a plurality of groups, and accordingly, the heat may be discharged through paths separated from each other. As described above, the embodiment allows at least one layer of insulating layer in which an outer through electrode is not disposed, so that heat generated in a chip is diverged and transferred through the outer through electrodes separated from each other. Accordingly, the embodiment may further improve heat dissipation performance.

In addition, the embodiment allows the inner through electrode disposed adjacent to the chip to have a large area in the shape of a bar extending in a longitudinal direction. Accordingly, the embodiment can efficiently transfer heat generated from the chip to the outer through electrode, thereby further improving heat dissipation performance.

In addition, the embodiment allows each outer through electrode to include a plurality of sub through electrodes (or through electrode parts) spaced apart in the second direction, so that the heat can be dissipated from a single outer through electrode through a plurality of branched paths, thereby further improving heat dissipation performance and improving product reliability.

In addition, the embodiment allows each outer through electrode to have a ' U ' shape or a '□' shape. Accordingly, when dissipating heat from each outer through electrode to a separation line through the plurality of sub through electrodes as described above, the embodiment can effectively prevent heat from being intensively dissipated to a specific sub-through electrode, thereby further improving heat dissipation characteristics.

In addition, the embodiment allows each outer through electrode to be exposed to different side surfaces of the circuit board. For example, the first outer through electrode of the embodiment may be exposed to a first side surface of the circuit board, and the second outer through electrode may be exposed to the second side surface opposite to the first side surface of the circuit board. Accordingly, the embodiment can further improve heat dissipation performance compared to dissipating heat only in one direction, and thereby improve product reliability.

### [Description of Drawings]

FIG. 1 is a view showing a circuit board according to a first embodiment.
FIG. 2 is a side view of the circuit board of FIG. 1.
FIG. 3 is a modified example of an outer through electrode shown in FIG. 1.
FIG. 4 is a plan view of an outer through electrode of FIG. 3.
FIG. 5 is a schematic plan view of a circuit board panel according to an embodiment.
FIGS. 6 and 7 are views for explaining circuit boards manufactured in a strip unit.
FIG. 8 is a view illustrating a circuit board according to a second embodiment.
FIG. 9 is a view illustrating a semiconductor package according to an embodiment.

### [Modes of the Invention]

Hereinafter, embodiments disclosed in the present specification will be described in detail with reference to the accompanying drawings, but identical or similar elements are denoted by the same reference numerals regardless of reference numerals, and redundant descriptions thereof will be omitted. The suffixes "module" and "portion" for the components used in the following description are given or used interchangeably in consideration of only the ease of writing the specification, and do not have meanings or roles that are distinguished from each other by themselves. In addition, in describing the embodiments disclosed in the present specification, if it is determined that a detailed description of related known technologies may obscure the subject matter of the embodiments disclosed in the present specification, the detailed description thereof will be omitted. In addition, the accompanying drawings are only for making it easier to understand the embodiments disclosed in the present specification, and the technical idea disclosed in the present specification is not limited by the accompanying drawings, and this should be understood to include all changes, equivalents, or substitutes included in the spirit and scope of the present invention.

Terms including ordinal numbers such as first and second may be used to describe various elements, but the elements are not limited by the terms. The above terms are used only for the purpose of distinguishing one component from another component.

When a component is referred to as being "contacted" or "connected" to another component, it may be directly connected or connected to the other component, but other components may exist in the middle. On the other hand, when a component is referred to as being "directly contacted" or "directly connected" to another component, it should be understood that there is no other component in the middle.

Singular expressions include plural expressions unless the context clearly indicates otherwise.

In the present application, terms such as "comprises" or "have" are intended to designate the presence of features, numbers, steps, actions, components, parts, or combinations thereof described in the specification, but one or more other features. It is to be understood that the presence or addition of elements or numbers, steps, actions, components, parts, or combinations thereof, does not preclude in advance the possibility of being excluded.

Hereinafter, the embodiment of the present invention will be described in detail with reference to the accompanying drawings.

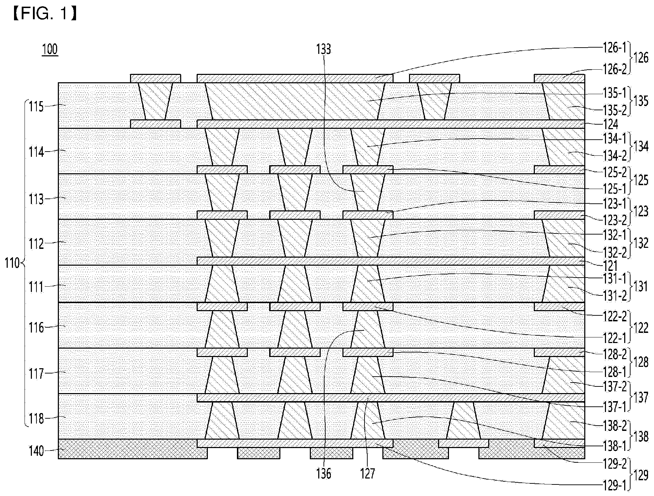

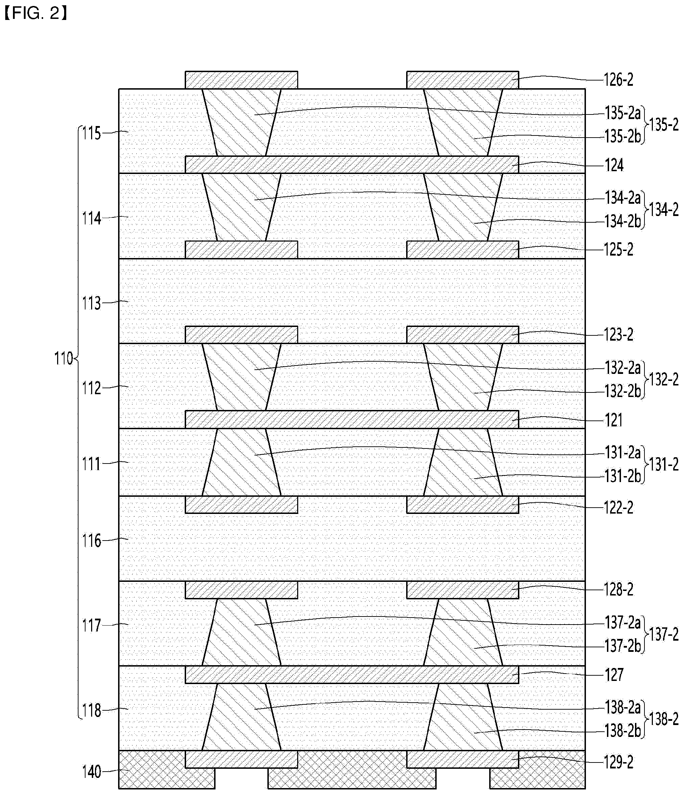

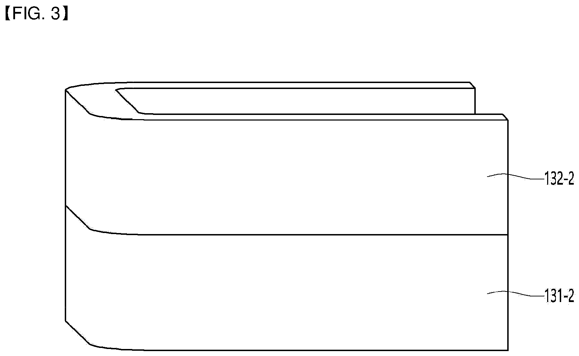

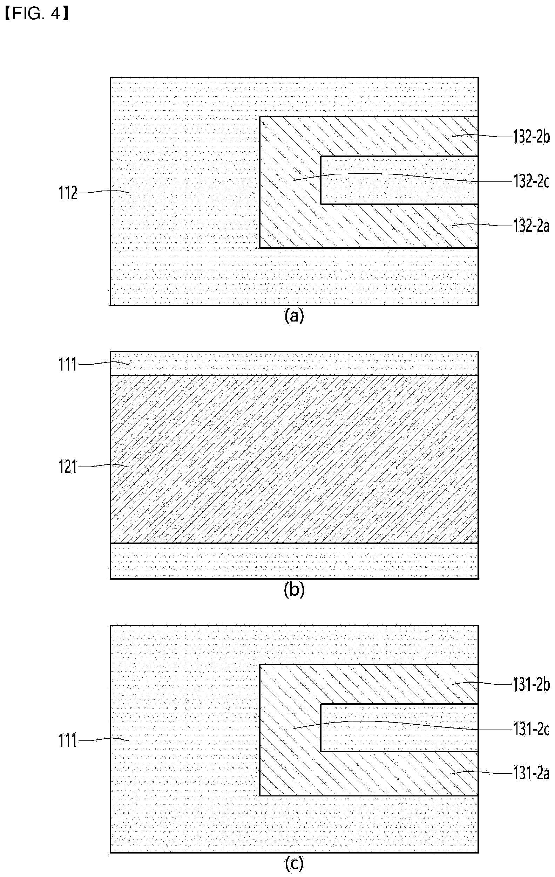

FIG. 1 is a view showing a circuit board according to a first embodiment, FIG. 2 is a side view of the circuit board of FIG. 1, FIG. 3 is a modified example of an outer through electrode shown in FIG. 1, and FIG. 4 is a plan view of an outer through electrode of FIG. 3.

Hereinafter, a circuit board with improved heat dissipation performance according to an embodiment will be described in detail with reference to FIGS. 1 and 2.

The circuit board 100 includes an insulating layer, a circuit pattern layer, a through part, and a protective layer. Such a circuit board 100 may have a multi-layer structure based on an insulating layer. For example, the circuit board 100 of the embodiment may be a multilayer board.

The insulating layer 110 may have a multi-layer structure. For example, the insulating layer 110 may have an eight-layer structure. Accordingly, the insulating layer 110 includes a first insulating layer 111, a second insulating layer 112, a third insulating layer 113, a fourth insulating layer 114, a fifth insulating layer 115, a sixth insulating layer 116, a seventh insulating layer 117, and an eighth insulating layer 118. Here, it is illustrated that the circuit board 100 has an 8-layer structure based on the number of insulating layers in the drawings, but the embodiment is not limited thereto. For example, the circuit board 100 may have fewer than 8 layers based on the number of layers of the insulating layer 110, or may have more layers than 8 layers.

The insulating layer 110 of the embodiment may be divided into a plurality of groups. For example, the insulating layer 110 may be divided into an inner insulating group, a first outer insulating group, and a second outer insulating group according to a position.

For example, the first insulating layer 111, the second insulating layer 112, the third insulating layer 113, and the sixth insulating layer 116 may belong to an inner insulating group. For example, the fourth insulating layer 114 and the fifth insulating layer 115 may belong to the first outer insulating group. For example, the seventh insulating layer 117 and the eighth insulating layer 118 may belong to the second outer insulating group.

The insulating layer 110 having such a multi-layer structure is a substrate on which an electric circuit capable of changing wiring is formed and may include all of a printed circuit board, a wiring board, and an insulating board that are made of an insulating material capable of forming circuit patterns on a surface thereof.

For example, at least one of the plurality of insulating layers 110 may be rigid or flexible. For example, at least one of the plurality of insulating layers 110 may include glass or plastic. In detail, at least one of the plurality of insulating layers 110 may include chemically tempered /semi-tempered glass such as soda lime glass or aluminosilicate glass, etc., a tempered or flexible plastic such as polyimide (PI), or polyethylene terephthalate (PET), propylene glycol (PPG), polycarbonate (PC), etc., or sapphire.

In addition, at least one of the plurality of insulating layers 110 may include an optical isotropic film. As an example, at least one of the plurality of insulating layers 110 may include cyclic olefin copolymer (COC), cyclic olefin polymer (COP), optical isotropic polycarbonate (PC), optical isotropic polymethyl methacrylate (PMMA), or the like.

In addition, at least one of the plurality of insulating layers 110 may be formed of a material including an inorganic filler and an insulating resin. For example, the material constituting at least one of the plurality of insulating layers 110 may include a resin including a reinforcing material such as an inorganic filler such as silica or alumina together with a thermosetting resin such as an epoxy resin or a thermoplastic resin such as polyimide, specifically, ABF (Ajinomoto Build-up Film), FR-4, BT (Bismaleimide Triazine), PID (Photo Imageable Dielectric Resin), BT, etc.

In addition, at least one of the plurality of insulating layers 110 may be partially bent while having a curved surface. That is, at least one of the plurality of insulating layers 110 may partially have a plane and may partially be bent while having a curved surface. Specifically, an end portion of the at least one of the plurality of insulating layers 110 may be bent while having a curved surface, or bent or crooked while having a surface with a random curvature.

The first insulating layer 111 may be disposed at a center of the circuit board 100. The second insulating layer 112 may be disposed on a first surface of the first insulating layer 111. The third insulating layer 113 may be disposed on the first surface of the second insulating layer 112. The fourth insulating layer 114 may be disposed on the first surface of the third insulating layer 113. The fifth insulating layer 115 may be disposed on the first surface of the fourth insulating layer 114. The sixth insulating layer 116 may be disposed on the second surface of the first insulating layer 111. The seventh insulating layer 117 may be disposed on the second surface of the sixth insulating layer 116. The eighth insulating layer 118 may be disposed on the second surface of the seventh insulating layer 117. Meanwhile, naming of each layer constituting the insulating layer 110 is only for distinguishing each layer, but is not limited thereto. For example, when naming is performed from an uppermost side of the circuit board 100, the fifth insulating layer 115 may be a first insulating layer.

Circuit pattern layers may be disposed on surfaces of the plurality of insulating layers 110, respectively. For example, a first circuit pattern layer may be disposed on the first surface of the first insulating layer 111. For example, a second circuit pattern layer may be disposed on the second surface of the first insulating layer 111. For example, a third circuit pattern layer may be disposed on the first surface of the second insulating layer 112. For example, a fourth circuit pattern layer may be disposed on the first surface of the third insulating layer 114. For example, a fifth circuit pattern layer may be disposed on the first surface of the fourth insulating layer 114. For example, a sixth circuit pattern layer may be disposed on the first surface of the fifth insulating layer 115. For example, a seventh circuit pattern layer may be disposed on the second surface of the sixth insulating layer 116. For example, an eighth circuit pattern layer may be disposed on the second surface of the seventh insulating layer 117. For example, a ninth circuit pattern layer may be disposed on the second surface of the eighth insulating layer 118.

The circuit pattern layers disposed on the first surface or the second surface of each insulating layer as described above may be divided into a plurality of parts according to functions. For example, the circuit pattern layers may be divided into a trace and a pad according to a function. The trace means a wiring in the form of a long line that transmits an electrical signal. The trace may have a relatively narrow line width and a relatively narrow pitch compared to the pad. The trace may be a fine circuit pattern. The pad may mean a through electrode pad connected to a through part, a mounting pad on which a part such as a chip is mounted, or a core pad or BGA pad for connection with an external board. At this time, the embodiment is characterized by a through part and a pad connected to the through part, and accordingly, the pad of the circuit pattern layer disposed on the first or second surface of each insulating layer will be mainly described. Accordingly, only the pads of each circuit pattern layer are shown in the drawings.

The circuit pattern layer as described may be formed of at least one metal material selected from among gold (Au), silver (Ag), platinum (Pt), titanium (Ti), tin (Sn), copper (Cu), and zinc (Zn). In addition, the circuit pattern layer as described above may be formed of paste or solder paste including at least one metal material selected from among gold (Au), silver (Ag), platinum (Pt), titanium (Ti), tin (Sn), copper (Cu), and zinc (Zn), which are excellent in bonding force. Preferably, the circuit pattern layer as described above may be formed of copper (Cu) having high electrical conductivity and a relatively low cost.

The circuit pattern layer may be formed by a general process of manufacturing a circuit board, such as an additive process, a subtractive process, a modified semi additive process (MSAP), a semi additive process (SAP), etc., and detailed descriptions thereof will be omitted herein.

A detailed description of the circuit pattern layer is as follows.

A first pad 121 may be disposed on a first surface of the first insulating layer 111. The first pad 121 may be a common pad. Here, the common pad may refer to a pad to which an inner through electrode and an outer through electrode described below are commonly connected. One side surface of the first pad 121 may be positioned on the same plane as an outer side surface of the first insulating layer 111. For example, an outer side surface of the first pad 121 may be disposed on the same line as the outer side surface of the first insulating layer 111 and the outer side surface of the circuit board 100, so that the first pad 121 may be exposed to the outside.

A second pad 122 may be disposed on the second surface of the first insulating layer 111. At this time, the second pad 122 may be divided into a plurality of sub pads according to an arrangement position. For example, the second pad 122 may include a second-first pad 122-1 disposed inside the second surface of the first insulating layer 111 and a second-second pad 122-2 disposed outside the second surface of the first insulating layer 111. In this case, at least one side surface of the second-second pad 122-2 may be positioned on the same plane as an outer side surface of the first insulating layer 111. For example, the second-second pad 122-2 may be disposed on the same line as the outer side surface of the first insulating layer 111 and the outer side surface of the circuit board 100, so that the second-second pad 122-2 may be exposed to the outside.

A third pad 123 may be disposed on the first surface of the second insulating layer 112. In this case, the third pad 123 may be divided into a plurality of sub pads according to an arrangement position. For example, the third pad 123 may include a third-first pad 123-1 disposed inside the first surface of the second insulating layer 112 and a third-second pad 123-2 disposed outside the first surface of the second insulating layer 112. In this case, at least one side surface of the third-second pad 123-2 may be positioned on the same plane as an outer side surface of the second insulating layer 112. For example, the third-second pad 123-2 may be disposed on the same line as the outer side surface of the second insulating layer 112 and the outer side surface of the circuit board 100, so that the third-second pad 123-2 may be exposed to the outside.

A fourth pad 124 may be disposed on the first surface of the fourth insulating layer 114. The fourth pad 124 may be a common pad. Here, the common pad may refer to a pad to which an inner through electrode and an outer through electrode described below are commonly connected. One side surface of the fourth pad 124 may be positioned on the same plane as an outer side surface of the fourth insulating layer 114. For example, the fourth pad 124 may be positioned on the same line as the outer side surface of the fourth insulating layer 114 and the outer side surface of the circuit board 100, so that the fourth pad 124 may be exposed to the outside.

A fifth pad 125 may be disposed on the first surface of the third insulating layer 113 or the second surface of the fourth insulating layer 114. In this case, the fifth pad 125 may be divided into a plurality of sub pads according to an arrangement position. For example, the fifth pad 125 may include a fifth-first pad 125-1 disposed inside the first surface of the third insulating layer 113 or the second surface of the fourth insulating layer 114, and a fifth-second pad 125-2 disposed outside the first surface of the third insulating layer 113 or the second surface of the fourth insulating layer 114. In this case, at least one side surface of the fifth-second pad 125-2 may be positioned on the same plane as outer side surfaces of the third insulating layer 113 and the fourth insulating layer 114. For example, the fifth-second pad 125-2 may be positioned on the same line as the outer side surface of the third insulating layer 113 and the fourth insulating layer 114 and the outer side surface of the circuit board 100, so that the fifth-second pad 125-2 may be exposed to the outside.

A sixth pad 126 may be disposed on the first surface of the fifth insulating layer 115. In this case, the sixth pad 126 may be divided into a plurality of sub pads according to an arrangement position. For example, the sixth pad 126 may include a sixth-first pad 126-1 disposed inside the first surface of the fifth insulating layer 115 and a sixth-second pad 126-2 disposed outside the first surface of the fifth insulating layer 115. In this case, at least one side surface of the sixth-second pad 126-2 may be positioned on the same plane as an outer side surface of the fifth insulating layer 115. For example, the sixth-second pad 126-2 may be positioned on the same line as the outer side surface of the fifth insulating layer 115 and the outer side surface of the circuit board 100, so that the sixth-second pad 126-2 may be exposed to the outside.

A seventh pad 127 may be disposed on the second surface of the seventh insulating layer 117. The seventh pad 127 may be a common pad. Here, the common pad may refer to a pad to which an inner through electrode and an outer through electrode described below are commonly connected. One side surface of the seventh pad 127 may be positioned on the same plane as an outer side surface of the seventh insulating layer 117. For example, the seventh pad 127 may be positioned on the same line as the outer side surface of the seventh insulating layer 117 and the outer side surface of the circuit board 100, so that the seventh pad 127 may be exposed to the outside.

An eighth pad 128 may be disposed on the second surface of the sixth insulating layer 116 or the first surface of the seventh insulating layer 117. In this case, the eighth pad 128 may be divided into a plurality of sub pads according to the arrangement position. For example, the eighth pad 128 may include an eighth-first pad 128-1 disposed inside the second surface of the sixth insulating layer 116 or the first surface of the seventh insulating layer 117, and a eighth-second pad 128-2 disposed outside the second surface of the sixth insulating layer 116 or the first surface of the seventh insulating layer 117. In this case, at least one side surface of the eighth-second pad 128-2 may be positioned on the same plane as an outer side surface of the sixth insulating layer 116 or the seventh insulating layer 117. For example, the eighth-second pad 128-2 may be positioned on the same line as the outer side surface of the sixth insulating layer 116 or the seventh insulating layer 117 and the outer side surface of the circuit board 100, so that the eighth-second pad 128-2 may be exposed to the outside.

A ninth pad 129 may be disposed on the second surface of the eighth insulating layer 118. In this case, the ninth pad 129 may be divided into a plurality of sub pads according to the arrangement position. For example, the ninth pad 129 may include a ninth-first pad 129-1 disposed inside the second surface of the eighth insulating layer 118 and a ninth-second pad 129-2 disposed outside the second surface of the eighth insulating layer 118. In this case, at least one side surface of the ninth-second pad 129-2 may be positioned on the same plane as an outer side surface of the eighth insulating layer 118. For example, the ninth-second pad 129-2 may be positioned on the same line as the outer side surface of the eighth insulating layer 118 and the outer side surface of the circuit board 100, so that the ninth-second pad 129-2 may be exposed to the outside.

The first to ninth pads 121, 122, 123, 124, 125, 126, 127, 128, and 129 of the embodiment may be divided into a plurality of groups based on an outer through electrode (or heat dissipation through electrode) described later. For example, the first pad 121, the second pad 122, and the third pad 123 may be grouped into a first group based on the outer through electrode. For example, the fourth pad 124, the fifth pad 125, and the sixth pad 126 may be grouped into a second group based on the outer through electrode. For example, the seventh pad 127, the eighth pad 128, and the ninth pad 129 may be grouped into a third group based on the outer through electrode. In this case, the pads grouped into the first group, the second group, and the third group may have structures corresponding to each other. For example, the first pad 121 of the first group, the fourth pad 124 of the second group, and the seventh pad 127 of the third group may correspond to each other. For example, the second pad 122 of the first group, the fifth pad 125 of the second group, and the eighth pad 128 of the third group may correspond to each other. For example, the third pad 123 of the first group, the sixth pad 126 of the second group, and the ninth pad 129 of the third group may correspond to each other.

Meanwhile, the circuit board 100 according to the embodiment includes a through part passing through the insulating layer 110.

For example, a first through part 131 may be disposed in the first insulating layer 111. For example, a second through part 132 may be disposed in the second insulating layer 112. For example, a third through part 133 may be disposed in the third insulating layer 113. For example, a fourth through part 134 may be disposed in the fourth insulating layer 114. For example, a fifth through part 135 may be disposed in the fifth insulating layer 115. For example, a sixth through part 136 may be disposed in the sixth insulating layer 116. For example, a seventh through part 137 may be disposed in the seventh insulating layer 117. For example, an eighth through part 138 may be disposed in the eighth insulating layer 118.

The first through part 131 may include a first-first through electrode 131-1 and a first-second through electrode 131-2 according to an arrangement position. The first-first through electrode 131-1 may be disposed inside the first insulating layer 111. The number of first-first through electrodes 131-1 may be provided in plurality. For example, the plurality of first-first through electrodes 131-1 may be disposed inside the first insulating layer 111 and spaced apart from each other in a first direction (or longitudinal direction or horizontal direction). The first surfaces of each of the plurality of first-first through electrodes 131-1 may be commonly connected to the first pad 121.

In addition, each second surface of the plurality of first-first through electrodes 131-1 may be individually connected to the second-first pad 122-1. For example, a plurality of second-first pads 122-1 may be disposed on the second surface of the first insulating layer 111 and spaced apart from each other in the first direction. In addition, the second surfaces of each of the plurality of first-first through electrodes 131-1 may be respectively connected to the plurality of second-first through pads 122-1. The first-second through electrode 131-2 may be disposed outside the first insulating layer 111. Here, being disposed outside may mean that the outer side surface of the first-second through electrode 131-2 is exposed through the outer side surface of the first insulating layer 111.

An outer side surface of the first-second through electrode 131-2 may be positioned on the same line as an outer side surface of the first insulating layer 111. For example, the first-second through electrode 131-2 may be positioned on the same plane as the outer side surface of the first insulating layer 111 and the outer side surface of the circuit board 100, so that the first-second through electrode 131-2 may be exposed to the outside.

A first surface of the first-second through electrode 131-2 may be connected to the first pad 121. In addition, the second surface of the first-second through electrode 131-2 may be connected to the second-second pad 122-2.

A width of the first-second through electrode 131-2 may be different from a width of the first-first through electrode 131-1. For example, the first-first through electrode 131-1 may have a first width. Also, the first-second through electrode 131-2 may have a second width different from the first width of the first-first through electrode 131-1. For example, the second width of the first-second through electrode 131-2 may have a range of 0.3 times to 2 times the first width of the first-first through electrode 131-1. For example, the second width of the first-second through electrode 131-2 may have a range of 0.5 to 2 times the first width of the first-first through electrode 131-1. For example, the second width of the first-second through electrode 131-2 may have a range of 0.7 to 2 times the first width of the first-first through electrode 131-1.

For example, when the second width of the first-second through electrode 131-2 is less than 0.3 times the first width of the first-first through electrode 131-1, the heat dissipation performance improvement effect achieved by the first-second through electrode 131-2 may be insufficient. For example, when the second width of the first-second through electrode 131-2 is smaller than 0.3 times the first width of the first-first through electrode 131-1, the heat dissipation performance of the circuit board 100 may decrease, and thus product performance may decrease. When the second width of the first-second through electrode 131-2 is smaller than 0.3 times the first width of the first-first through electrode 131-1, a sawing strength is higher than the adhesive strength between the through electrode and the insulating layer, a filling material of the through electrode constituting the first-second through electrode 131-2 may be separated from the insulating layer, and thus a circuit disconnection may occur. The embodiment allows the first-second through electrode 131-2 to be exposed through the outer side surface of the first insulating layer 111 and further the outer side surface of the circuit board 100, and through this, heat dissipation of a chip, which will be described later, can be achieved, thereby improving heat dissipation performance of a circuit board.

Meanwhile, the first-first through electrode 131-1 may have a shape different from a shape of the first-second through electrode 131-2. For example, the first side surface and the second side surface of the first-first through electrode 131-1 may include inclined surfaces whose widths change toward a lower or upper direction. For example, the first-second through electrode 131-2 may have a first side surface including an inclined surface and a second side surface including a vertical surface. For example, the second side surface of the first-second through electrode 131-2 may be perpendicular to the first surface or the second surface of the first insulating layer 111.

The first-first through electrode 131-1 may be referred to as a first inner through electrode disposed inside the first insulating layer 111, and the first-second through electrode 131-2 may also be referred to as a first outer through electrode disposed outside the first insulating layer 111.

The second through part 132 may include a second-first through electrode 132-1 and a second-second through electrode 132-2 according to the arrangement position. The second-first through electrode 132-1 may be disposed inside the first insulating layer 112. The number of second-first through electrodes 132-1 may be provided in plurality. For example, a plurality of second-first through electrodes 132-1 may be disposed inside the second insulating layer 112 and spaced apart from each other in a first direction (or longitudinal direction or horizontal direction). The second surfaces of each of the plurality of second-first through electrodes 132-1 may be commonly connected to the first pad 121.

In addition, each second surface of the plurality of second-first through electrodes 132-1 may be individually connected to the third-first pad 123-1. For example, a plurality of third-first pads 123-1 may be disposed on the first surface of the second insulating layer 112 and spaced apart from each other in the first direction. In addition, the second surfaces of each of the plurality of second-first through electrodes 132-1 may be respectively connected to the plurality of third-first through electrodes 123-1.

The second-second through electrode 132-2 may be disposed outside the second insulating layer 112. Here, being disposed outside may mean that the outer side surface of the second-second through electrode 132-2 is exposed through the outer side surface of the second insulating layer 112.

An outer side surface of the second-second through electrode 132-2 may be positioned on the same line as an outer side surface of the second insulating layer 112. For example, the second-second through electrode 132-2 may be positioned on the same line as the outer side surface of the second insulating layer 112 and the outer side surface of the circuit board 100, so that the second-second through electrode 132-2 may be exposed to the outside.

A second surface of the second-second through electrode 132-2 may be connected to the first pad 121. In addition, the first surface of the second-second through electrode 132-2 may be connected to the third-second pad 123-2.

A width of the second-second through electrode 132-2 may be different from a width of the second-first through electrode 132-1. For example, the second-first through electrode 132-1 may have a first width. Also, the second-second through electrode 132-2 may have a second width different from the first width of the second-first through electrode 132-1. For example, the second width of the second-second through electrode 132-2 may be 0.3 times or more of the first width of the second-first through electrode 132-1. For example, the second width of the second-second through electrode 132-2 may be 0.5 times or more of the first width of the second-first through electrode 132-1. For example, the second width of the second-second through electrode 132-2 may be 0.7 times or more of the first width of the second-first through electrode 132-1. For example, the second width of the second-second through electrode 132-2 may be less than 2 times the first width of the second-first through electrode 132-1.

For example, when the second width of the second-second through electrode 132-2 is smaller than 0.3 times the first width of the second-first through electrode 132-1, the heat dissipation performance improvement effect achieved by the second-second through electrode 132-2 may be insufficient. For example, when the second width of the second-second through electrode 132-2 is smaller than 0.3 times the first width of the second-first through electrode 132-1, the heat dissipation performance of the circuit board 100 may decrease, and thus product performance may decrease. When the second width of the second-second through electrode 132-2 is smaller than 0.3 times the first width of the second-first through electrode 132-1, a sawing strength is higher than the adhesive strength between the through electrode and the insulating layer, a filling material of the through electrode constituting the second-second through electrode 132-2 may be separated from the insulating layer, and thus a circuit disconnection may occur.

Meanwhile, the second-first through electrode 132-1 may have a shape different from a shape of the second-second through electrode 132-2. For example, a first side surface and a second side surface of the second-first through electrode 132-1 may include a inclined surface. For example, a first side surface of the second-second through electrode 132-2 may include an inclined surface and a second side surface of the second-second through electrode 132-2 may include a vertical surface. For example, the second side surface of the second-second through electrode 132-2 may be perpendicular to the first surface or the second surface of the second insulating layer 112.

The second-first through electrode 132-1 may be referred to as a second inner through electrode disposed inside the second insulating layer 112, and the second-second through electrode 132-2 may be referred to as a second outer through electrode disposed outside the first insulating layer 112.

In addition, the second-second through electrode 132-2 may overlap the first-second through electrode 131-2 in a thickness direction.

The third through part 133 may be disposed only inside the third insulating layer 113. For example, the third through part 133 may not be exposed through an outer side surface of the third insulating layer 113. For example, the third through part 133 may be selectively disposed only in a region of the third insulating layer 133 overlapping the first-first through electrode 131-1 and the second-first through electrode 132-1 in the thickness direction. For example, the third through part 133 may not be disposed in a region of the third insulating layer 113 overlapping the second-second through electrode 132-2 and the first-second through electrode 131-2 in the thickness direction.

That is, the embodiment allows a through part not to be disposed on an outer side surface of at least one insulating layer among the multi-layered insulating layers constituting the insulating layer 110. That is, outer through electrodes disposed on the outer side surface of the insulating layer of the embodiment may have a two-layer structure. For example, the embodiment allows outer through electrodes to be formed on the first insulating layer 111 and the second insulating layer 112, respectively. Accordingly, an outer through electrode is not provided in the sixth insulating layer 116 adjacent to the first insulating layer 111 and the third insulating layer 113 adjacent to the second insulating layer 112. This is because, when the outer through electrodes are provided in all layers constituting the insulating layer 110, the process of plating the outer through electrodes may be difficult, and thus a problem may occur in reliability of the outer through electrodes. Furthermore, when the outer through electrodes are provided in all layers constituting the insulating layer 110, there is a problem that the heat dissipation performance is deteriorated as the heat generated in the chip is transferred to the entire insulating layer. Therefore, the embodiment allows at least one insulating layer in which the outer through electrode is not disposed as described above to be provided, so that the heat generated in the chip is branched and transferred through the outer through electrodes separated from each other. Accordingly, the embodiment can further improve heat dissipation performance.

Meanwhile, a plurality of third through parts 133 may be disposed inside the third insulating layer 113. In addition, a first surface of the third through part 133 may be connected to the fifth-first pad 125-1, and a second surface of the third through part 133 may be connected to the third-first pad 123-1.

In an embodiment, the first insulating layer 111 and the second insulating layer 112 may form one layer group, and accordingly, the first-second through electrode 131-2 and the second-second through electrode 132-2 respectively disposed in the first insulating layer 111 and the second insulating layer 112 can form a first outer through electrode group. Accordingly, the first outer through electrode group may provide a first heat transfer path through which heat generated in the chip is dissipated.

The fourth through part 134 may include a fourth-first through electrode 134-1 and a fourth-second through electrode 134-2 according to an arrangement position. The fourth-first through electrode 134-1 may be disposed inside the fourth insulating layer 114. The number of fourth-first through electrodes 134-1 may be provided in plurality. For example, a plurality of fourth-first through electrodes 134-1 may be disposed inside the fourth insulating layer 114 and spaced apart from each other in a first direction (or longitudinal direction or horizontal direction). The first surfaces of each of the plurality of fourth-first through electrodes 134-1 may be commonly connected to the fourth pad 124.

In addition, each second surface of the plurality of fourth-first through electrodes 134-1 may be individually connected to the fifth-first pad 125-1. For example, a plurality of fifth-first pads 125-1 may be disposed on the first surface of the third insulating layer 113 and spaced apart from each other in the first direction. In addition, the second surfaces of each of the plurality of fourth-first through electrodes 134-1 may be respectively connected to the plurality of fifth-first pads 125-1. The fourth-second through electrode 134-2 may be disposed outside the fourth insulating layer 114. Here, being disposed outside may mean that the outer side surface of the fourth-second through electrode 134-2 is exposed through the outer side surface of the fourth insulating layer 114.

An outer side surface of the fourth-second through electrode 134-2 may be positioned on the same line as an outer side surface of the fourth insulating layer 114. For example, the fourth-second through electrode 134-2 may be positioned on the same line as the outer side surface of the fourth insulating layer 114 and the outer side surface of the circuit board 100, so that the fourth-second through electrode 134-2 may be exposed to the outside.

A first surface of the fourth-second through electrode 134-2 may be connected to the fourth pad 124. In addition, a second surface of the fourth-second through electrode 134-2 may be connected to the fifth-second pad 125-2.

A width of the fourth-second through electrode 134-2 may be different from a width of the fourth-first through electrode 134-1. For example, the fourth-first through electrode 134-1 may have a first width. In addition, the fourth-second through electrode 134-2 may have a second width different from the first width of the fourth-first through electrode 134-1. For example, the second width of the fourth-second through electrode 134-2 may be times or more of the first width of the fourth-first through electrode 134-1. For example, the second width of the fourth-second through electrode 134-2 may be 0.5 times or more of the first width of the fourth-first through electrode 134-1. For example, the second width of the fourth-second through electrode 134-2 may be 0.7 times or more of the first width of the fourth-first through electrode 134-1. For example, the second width of the fourth-second through electrode 134-2 may be less than 2 times the first width of the fourth-first through electrode 134-1.

For example, when the second width of the fourth-second through electrode 134-2 is smaller than 0.3 times the first width of the fourth-first through electrode 134-1, the heat dissipation performance improvement effect achieved by the fourth-second through electrode 134-2 may be insufficient. For example, when the second width of the fourth-second through electrode 134-2 is smaller than 0.3 times the first width of the fourth-first through electrode 134-1, the heat dissipation performance of the circuit board 100 may decrease, and thus product performance may decrease. When the second width of the fourth-second through electrode 134-2 is smaller than 0.3 times the first width of the fourth-first through electrode 134-1, a sawing strength is higher than the adhesive strength between the through electrode and the insulating layer, a filling material of the through electrode constituting the fourth-second through electrode 134-2 may be separated from the insulating layer, and thus a circuit disconnection may occur. The embodiment allows the fourth-second through electrode 134-2 to be exposed through the outer side surface of the fourth insulating layer 114 and further the outer side surface of the circuit board 100. Accordingly, the embodiment allows heat dissipation of a chip to be described later, and thereby improves heat dissipation performance of a circuit board.

Meanwhile, the fourth-first through electrode 134-1 may have a shape different from a shape of the fourth-second through electrode 134-2. For example, first and second side surfaces of the fourth-first through electrode 134-1 may include an inclined surface. For example, a first side surface of the fourth-second through electrode 134-2 may include an inclined surface and a second side surface may include a vertical surface. For example, the second side surface of the fourth-second through electrode 134-2 may be perpendicular to the first surface or the second surface of the fourth insulating layer 114.

The fourth-first through electrode 134-1 may be referred to as a fourth inner through electrode disposed inside the fourth insulating layer 114, and the fourth-second through electrode 134-2 may be referred to as a fourth outer through electrode disposed outside the insulating layer 114.

The fifth through part 135 may include a fifth-first through electrode 135-1 and a fifth-second through electrode 135-2 according to an arrangement position. The fifth-first through electrode 135-1 may be disposed inside the fifth insulating layer 115. The number of fifth-first through electrodes 135-1 may be provided in plurality. The fifth insulating layer 115 may be an outermost insulating layer disposed at an outermost side of the plurality of insulating layers 110. Accordingly, the fifth-first through electrode 135-1 may be positioned closest to a later chip. Accordingly, the embodiment allows the fifth-first through electrode 135-1 to be provided as a through electrode having a large area unlike other inner through electrodes. For example, the fifth-first through electrode 135-1 may have a greater width than a width of each of the first-first through electrode 131-1, the second-first through electrode 132-1, and the fourth-first through electrode 134-1. For example, the fifth-first through electrode 135-1 may have a bar shape elongated in the first direction. A width of the fifth-first through electrode 135-1 may be more than twice the width of each of the first-first through electrode 131-1, the second-first through electrode 132-1, and the fourth-first through electrode 134-1. A width of the fifth-first through electrode 135-1 may be more than 3 times the width of each of the first-first through electrode 131-1, the second-first through electrode 132-1, and the fourth-first through electrode 134-1. A width of the fifth-first through electrode 135-1 may be more than 5 times the width of each of the first-first through electrode 131-1, the second-first through electrode 132-1, and the fourth-first through electrode 134-1. A width of the fifth-first through electrode 135-1 may be more than 10 times the width of each of the first-first through electrode 131-1, the second-first through electrode 132-1, and the fourth-first through electrode 134-1.

Meanwhile, it is illustrated that only the fifth-first through electrode 135-1, which is the inner through electrode of the fifth through part 135, is provided as a bar through electrode (bar via) as described above, but the embodiment is not limited thereto. For example, at least one of the previously described first-first through electrode 131-1, second-first through electrode 132-1, and fourth-first through electrode 134-1 may be provided as a bar through electrode corresponding to the fifth-first through electrode 135-1.

A first surface of the fifth-first through electrode 135-1 may be connected to the sixth-first pad 126-1, and a second surface of the fifth-first through electrode 135-1 may be connected to the fourth pad 124.

The fifth-second through electrode 135-2 may be disposed outside the fifth insulating layer 115. Here, being disposed outside may mean that the outer side surface of the fifth-second through electrode 135-2 is exposed through the outer side surface of the fifth insulating layer 115.

An outer side surface of the fifth-second through electrode 135-2 may be positioned on the same plane as an outer side surface of the fifth insulating layer 115. For example, the fifth-second through electrode 135-2 may be positioned on the same plane as the outer side surface of the fifth insulating layer 115 and the outer side surface of the circuit board 100, so that the fifth-second through electrode 135-2 may be exposed to the outside.

A second surface of the fifth-second through electrode 135-2 may be connected to the fourth pad 124. In addition, the first surface of the fifth-second through electrode 135-2 may be connected to the sixth-second pad 126-2.

Meanwhile, the fifth-first through electrode 135-1 may have a shape different from a shape of the fifth-second through electrode 135-2. For example, first and second sides of the fifth-first through electrode 135-1 may include an inclined surface. For example, a first side surface of the fifth-second through electrode 135-2 may include an inclined surface and a second side surface of the fifth-second through electrode 135-2 may include a vertical surface. For example, the second side surface of the fifth-second through electrode 135-2 may be perpendicular to the first surface or the second surface of the fifth insulating layer 115.

The fifth-first through electrode 135-1 may be referred to as a fifth inner through electrode disposed inside the fifth insulating layer 115, and the fifth-second through electrode 135-2 may be referred to as a fifth outer through electrode disposed outside the insulating layer 115.

In addition, the fifth-second through electrode 135-2 may overlap the fourth-second through electrode 134-2 in a thickness direction.

In the embodiment, the fourth insulating layer 114 and the fifth insulating layer 115 may form one layer group, and accordingly, the fourth-second through electrode 134-2 and the fifth-second through electrode 135-2 respectively disposed in the fourth insulating layer 114 and the fifth insulating layer 115 can form a second outer through electrode group. Accordingly, the second outer through electrode group may provide a second heat transfer path through which heat generated in the chip is dissipated. In this case, the second heat transfer path may be spaced apart from the first heat transfer path in a thickness direction so as not to directly contact the first heat transfer path.

The sixth through part 136 may be disposed only inside the sixth insulating layer 116. For example, the sixth through part 136 may not be exposed through an outer side surface of the sixth insulating layer 116. For example, the sixth through part 136 may be selectively disposed only in a region of the sixth insulating layer 136 overlapping the first-first through electrode 131-1 and the second-first through electrode 132-1 in the thickness direction. For example, the sixth through part 136 may not be disposed in a region of the sixth insulating layer 116 overlapping the second-second through electrode 132-2 and the first-second through electrode 131-2 in the thickness direction.

That is, the embodiment allows a through part not to be disposed on an outer side surface of at least one insulating layer among the multi-layered insulating layers constituting the insulating layer 110. That is, outer through electrodes disposed on the outer side surface of the insulating layer of the embodiment may have a two-layer structure. For example, the embodiment allows outer through electrodes to be formed on the first insulating layer 111 and the second insulating layer 112, respectively. Accordingly, an outer through electrode is not provided in the sixth insulating layer 116 adjacent to the first insulating layer 111. This is because, when the outer through electrodes are provided in all layers constituting the insulating layer 110, the process of plating the outer through electrodes may be difficult, and thus a problem may occur in reliability of the outer through electrodes. Furthermore, when the outer through electrodes are provided in all layers constituting the insulating layer 110, there is a problem that the heat dissipation performance is deteriorated as the heat generated in the chip is transferred to the entire insulating layer. Therefore, the embodiment allows at least one insulating layer in which the outer through electrode is not disposed as described above to be provided, so that the heat generated in the chip is branched and transferred through the outer through electrodes separated from each other. Accordingly, the embodiment can further improve heat dissipation performance.

Meanwhile, a plurality of the sixth through part 136 may be disposed inside the sixth insulating layer 116. In addition, a first surface of the sixth through part 136 may be connected to the second-first pad 122-1, and a second surface of the sixth through part 136 may be connected to the seventh-first pad 127-1.

The seventh through part 137 may include a seventh-first through electrode 137-1 and a seventh-second through electrode 137-2 according to an arrangement position. The seventh-first through electrode 137-1 may be disposed inside the seventh insulating layer 117. The number of seventh-first through electrodes 137-1 may be provided in plurality. For example, a plurality of seventh-first through electrodes 137-1 may be disposed inside the seventh insulating layer 117 and spaced apart from each other in a first direction (or longitudinal direction or horizontal direction). The second surfaces of each of the plurality of seventh-first through electrodes 137-1 may be commonly connected to the seventh pad 127.

In addition, each first surface of the plurality of seventh-first through electrodes 137-1 may be individually connected to the eighth-first pad 128-1. For example, a plurality of eighth-first pads 128-1 may be disposed on the second surface of the sixth insulating layer 116 and spaced apart from each other in the first direction. In addition, the second surfaces of each of the plurality of seventh-first through electrodes 137-1 may be respectively connected to the plurality of eighth-first through electrodes 128-1.

The seventh-second through electrode 137-2 may be disposed outside the seventh insulating layer 117. Here, being disposed outside may mean that an outer side surface of the seventh-second through electrode 137-2 is exposed through the outer side surface of the seventh insulating layer 117.

An outer side surface of the seventh-second through electrode 137-2 may be positioned on the same plane as an outer side surface of the seventh insulating layer 117. For example, the seventh-second through electrode 137-2 may be positioned on the same line as the outer side surface of the seventh insulating layer 117 and the outer side surface of the circuit board 100, so that the seventh-second through electrode 137-2 may be exposed to the outside.

A first surface of the seventh-second through electrode 137-2 may be connected to the eighth-second pad 128-2. In addition, the second surface of the seventh-second through electrode 137-2 may be connected to the seventh pad 127.

A width of the seventh-second through electrode 137-2 may be different from a width of the seventh-first through electrode 137-1. For example, the seventh-first through electrode 137-1 may have a first width. In addition, the seventh-second through electrode 137-2 may have a second width different from the first width of the seventh-first through electrode 137-1. For example, the second width of the seventh-second through electrode 137-2 may be 0.3 times or more of the first width of the seventh-first through electrode 137-1. For example, the second width of the seventh-second through electrode 137-2 may be 0.5 times or more of the first width of the seventh-first through electrode 137-1. For example, the second width of the seventh-second through electrode 137-2 may be 0.7 times or more of the first width of the seventh-first through electrode 137-1. The second width of the seventh-second through electrode 137-2 may be less than twice the first width of the seventh-first through electrode 137-1.

For example, when the second width of the seventh-second through electrode 137-2 is smaller than 0.3 times the first width of the seventh-first through electrode 137-1, the heat dissipation performance improvement effect achieved by the seventh-second through electrode 137 may be insufficient. For example, when the second width of the seventh-second through electrode 137-2 is smaller than 0.3 times the first width of the seventh-first through electrode 137-1, the heat dissipation performance of the circuit board 100 may decrease, and thus product performance may decrease. When the second width of the seventh-second through electrode 137-2 is smaller than 0.3 times the first width of the seventh-first through electrode 137-1, a sawing strength is higher than the adhesive strength between the through electrode and the insulating layer, a filling material of the through electrode constituting the seventh-second through electrode 137-2 may be separated from the insulating layer, and thus a circuit disconnection may occur. The embodiment allows the seventh-second through electrode 137-2 to be exposed through the outer side surface of the seventh insulating layer 117 and further the outer side surface of the circuit board 100. Accordingly, the embodiment allows heat dissipation of a chip to be described later, and thereby improves heat dissipation performance of a circuit board.

Meanwhile, the seventh-first through electrode 137-1 may have a shape different from a shape of the seventh-second through electrode 137-2. For example, first and second side surfaces of the seventh-first through electrode 137-1 may include an inclined surface. For example, a first side surface of the seventh-second through electrode 137-2 may include an inclined surface and a second side surface of the seventh-second through electrode 137-2 may include a vertical surface. For example, the second side surface of the seventh-second through electrode 137-2 may be perpendicular to the first surface or the second surface of the seventh insulating layer 117.

The seventh-first through electrode 137-1 may be referred to as a seventh inner through electrode disposed inside the seventh insulating layer 117, and the seventh-second through electrode 137-2 may be referred to as a seventh outer through electrode disposed outside the insulating layer 117.

The eighth through part 138 may include an eighth-first through electrode 138-1 and an eighth-second through electrode 138-2 according to an arrangement position. The eighth-first through electrode 138-1 may be disposed inside the eighth insulating layer 118. The number of eighth-first through electrodes 138-1 may be provided in plurality. For example, a plurality of eighth-first through electrodes 138-1 may be disposed inside the eighth insulating layer 118 and spaced apart from each other in a first direction (or longitudinal direction or horizontal direction). The first surfaces of each of the plurality of eighth-first through electrodes 138-1 may be commonly connected to the seventh pad 127.

In addition, each second surface of the plurality of eighth-first through electrodes 138-1 may be individually connected to the ninth-first pad 129-1. For example, a plurality of the ninth-first pads 129-1 may be disposed on the second surface of the eighth insulating layer 118 and spaced apart from each other in the first direction. In addition, the second surfaces of each of the plurality of eighth-first through electrodes 138-1 may be respectively connected to the plurality of ninth-first through electrodes 129-1.

The eighth-second through electrode 138-2 may be disposed outside the eighth insulating layer 118. Here, being disposed outside may mean that an outer side surface of the eighth-second through electrode 138-2 is exposed through the outer side surface of the eighth insulating layer 118.

An outer side surface of the eighth-second through electrode 138-2 may be positioned on the same plane as an outer side surface of the eighth insulating layer 118. For example, the eighth-second through electrode 138-2 may be positioned on the same line as the outer side surface of the eighth insulating layer 118 and the outer side surface of the circuit board 100, so that the eighth-second through electrode 138-2 may be exposed to the outside.

A first surface of the eighth-second through electrode 138-2 may be connected to the seventh pad 127. In addition, a second surface of the eighth-second through electrode 138-2 may be connected to the ninth-second pad 129-2.

A width of the eighth-second through electrode 138-2 may be different from a width of the eighth-first through electrode 138-1. For example, the eighth-first through electrode 138-1 may have a first width. In addition, the eighth-second through electrode 138-2 may have a second width different from the first width of the eighth-first through electrode 138-1. For example, the second width of the eighth-second through electrode 138-2 may be 0.3 times or more of the first width of the eighth-first through electrode 138-1. For example, the second width of the eighth-second through electrode 138-2 may be 0.5 times or more of the first width of the eighth-first through electrode 138-1. For example, the second width of the eighth-second through electrode 138-2 may be 0.7 times or more of the first width of the eighth-first through electrode 138-1. For example, the second width of the eighth-second through electrode 138-2 may be less than twice the first width of the eighth-first through electrode 138-1.

For example, when the second width of the eighth-second through electrode 138-2 is smaller than 0.3 times the first width of the eighth-first through electrode 138-1, the heat dissipation performance improvement effect achieved by the eighth-second through electrode 138 may be insufficient. For example, when the second width of the eighth-second through electrode 138-2 is smaller than 0.3 times the first width of the eighth-first through electrode 138-1, the heat dissipation performance of the circuit board 100 may decrease, and thus product performance may decrease. When the second width of the eighth-second through electrode 138-2 is smaller than 0.3 times the first width of the eighth-first through electrode 138-1, a sawing strength is higher than the adhesive strength between the through electrode and the insulating layer, a filling material of the through electrode constituting the first-second through electrode 131-2 may be separated from the insulating layer, and thus a circuit disconnection may occur. The embodiment allows the eighth-second through electrode 138-2 to be exposed through the outer side surface of the eighth insulating layer 118 and further the outer side surface of the circuit board 100. Accordingly, the embodiment allows heat dissipation of a chip to be described later, and thereby improves heat dissipation performance of a circuit board.

Meanwhile, the eighth-first through electrode 138-1 may have a shape different from a shape of the eighth-second through electrode 138-2. For example, first and second sides of the eighth-first through electrode 138-1 may include an inclined surface. For example, a first side surface of the eighth-second through electrode 138-2 may include an inclined surface and a second side surface of the eighth-second through electrode 138-2 may include a vertical surface. For example, the second side surface of the eighth-second through electrode 138-2 may be perpendicular to the first surface or the second surface of the eighth insulating layer 118.

The eighth-first through electrode 138-1 may be referred to as an eighth inner through electrode disposed inside the eighth insulating layer 118, and the eighth-second through electrode 138-2 may be referred to as an eighth outer through electrode disposed outside the insulating layer 118.

In addition, the eighth-first through electrode 138-1 may overlap the eighth-second through electrode 138-2 in a thickness direction.

In an embodiment, the seventh insulating layer 117 and the eighth insulating layer 118 may form one layer group, and accordingly, the seventh-second through electrode 137-2 and the eighth-second through electrode 138-2 respectively disposed in the seventh insulating layer 117 and the eighth insulating layer 118 can form a third outer through electrode group. Accordingly, the third outer through electrode group may provide a third heat transfer path through which heat generated in the chip is dissipated. In this case, the third heat transfer path formed by the third outer through electrode group may be spaced apart from each of the first and second heat transfer paths in a thickness direction so as not to directly contact each of the first and second heat transfer paths.

As described above, the embodiment provides an inner through electrode and an outer through electrode connected to the inner through electrode in each insulating layer and allows the outer through electrode to be exposed to the outside through the outer side surface of each insulating layer. Accordingly, the embodiment allows a transfer path of heat generated in the chip to be formed through the outer through electrode, and accordingly, it is possible to improve heat dissipation performance. Furthermore, the embodiment allows a plurality of heat transfer paths spaced apart in the thickness direction to be formed on the circuit board, and accordingly, heat generated in the chip is branched and dissipated through the plurality of heat transfer paths, thereby further improving heat dissipation performance.

Hereinafter, an outer through electrode according to an embodiment will be described in more detail.

First, the outer through electrode of the embodiment includes a first-second through electrode 131-2, a second-second through electrode 132-2, a fourth-second through electrode 134-2, a fifth-second through electrode 135-2, a seventh-second through electrode 137-2 and an eighth-second through electrode 138-2.

At this time, each of the first-second through electrode 131-2, the second-second through electrode 132-2, the fourth-second through electrode 134-2, the fifth-second through electrode 135-2, the seventh-second through electrode 137-2 and the eighth-second through electrode 138-2 may include a plurality of sub through electrodes (or through electrode parts) spaced apart in the second direction and exposed through an outer side surface of each insulating layer and further through an outer side surface of the circuit board 100.

For example, the first-second through electrodes 131-2 may include a plurality of first-second sub through electrodes 131-2a and 131-2b spaced apart from each other in the second direction, and an outer side surface of each of the plurality of first-second sub through electrodes 131-2a and 131-2b may be exposed through the outer side surface of the circuit board.

For example, the second-second through electrodes 132-2 may include a plurality of second-second sub through electrodes 132-2a and 132-2b spaced apart from each other in the second direction, and an outer side surface of each of the plurality of second-second sub through electrodes 132-2a and 132-2b may be exposed through the outer side surface of the circuit board.

For example, the fourth-second through electrodes 134-2 may include a plurality of fourth-second sub through electrodes 134-2a and 134-2b spaced apart from each other in the second direction, and an outer side surface of each of the plurality of fourth-second sub through electrodes 134-2a and 134-2b may be exposed through the outer side surface of the circuit board.

For example, the fifth-second through electrodes 135-2 may include a plurality of fifth-second sub through electrodes 135-2a and 135-2b spaced apart from each other in the second direction, and an outer side surface of each of the plurality of fifth-second sub through electrodes 135-2a and 135-2b may be exposed through the outer side surface of the circuit board.

For example, the seventh-second through electrodes 137-2 may include a plurality of seventh-second sub through electrodes 137-2a and 137-2b spaced apart from each other in the second direction, and an outer side surface of each of the plurality of seventh-second sub through electrodes 137-2a and 137-2b may be exposed through the outer side surface of the circuit board.

For example, the eighth-second through electrodes 138-2 may include a plurality of eighth-second sub through electrodes 135-8a and 138-2b spaced apart from each other in the second direction, and an outer side surface of each of the plurality of eighth-second sub through electrodes 138-2a and 138-2b may be exposed through the outer side surface of the circuit board.

As described above, the embodiment allows each outer through electrode to include a plurality of sub through electrodes spaced apart in the second direction, thereby further improving heat dissipation performance of the heat generated from the chip and improving product reliability.

Meanwhile, referring to FIGS. 3 and 4, each of the outer through electrodes according to the embodiment may have a ' U ' shape.

For example, the first-second through electrode 131-2 and the second-second through electrode 132-2 may have a ' U ' shape.

For example, the first-second through electrodes 131-2 may include a plurality of first-second sub through electrodes 131-2a and 131-2b spaced apart from each other in the second direction, and an outer side surface of each of the plurality of first-second sub through electrodes 131-2a and 131-2b may be exposed through the outer side surface of the circuit board. At this time, the first-second through electrode 131-2 may include a first connection through electrode 131-2c disposed in the second direction in the first insulating layer 111 and connecting the plurality of first-second sub-through electrodes 131-2a and 131-2b.

For example, the second-second through electrodes 132-2 may include a plurality of second-second sub through electrodes 132-2a and 132-2b spaced apart from each other in the second direction, and an outer side surface of each of the plurality of second-second sub through electrodes 132-2a and 132-2b may be exposed through the outer side surface of the circuit board. At this time, the second-second through electrode 132-2 may include a second connection through electrode 132-2c disposed in the second direction in the second insulating layer 112 and connecting the plurality of second-second sub-through electrodes 132-2a and 132-2b.

In addition, the first surface of the first pad 121 is connected in common with the second connection through electrode 132-2c connecting the plurality of second-second sub through electrodes 132-2a and 132-2b, and the second surface of the first pad 121 may be connected in common with the first connection through electrode 131-2c connecting the plurality of first-second sub through electrodes 131-2a and 131-2b. Accordingly, when dissipating heat from each outer through electrode to a separation line through the plurality of sub through electrodes as described above, the embodiment can effectively prevent heat from being intensively dissipated to a specific sub-through electrode, thereby further improving heat dissipation characteristics.

Meanwhile, the fourth-second through electrode 134-2 may further include a plurality of fourth-second sub through electrodes 134-2a and 134-2b and a fourth connection through electrode (not shown) connecting the plurality of fourth-second sub through electrodes 134-2a and 134-2b. In addition, the fifth-second through electrode 135-2 may further include a plurality of fifth-second sub through electrodes 135-2a and 135-2b and a fifth connection through electrode (not shown) connecting the plurality of fifth-second sub through electrodes 135-2a and 135-2b. In addition, the seventh-second through electrode 137-2 may further include a plurality of seventh-second sub through electrodes 137-2a and 137-2b and a seventh connection through electrode connecting the seventh-second through electrode 137-2. In addition, the eighth-second through electrode 138-2 may further include a plurality of eighth-second sub-through electrodes 137-2a and 137-2b and an eighth connection through electrode connecting the plurality of eighth-second sub-through electrodes 137-2a and 137-2b.

Meanwhile, the embodiment is not limited thereto, and the outer through electrodes as described above may have a "a" shape, thereby further maximizing heat dissipation performance.

Meanwhile, the through parts may be formed by filling an inside of a through-hole (not shown) passing through each of the plurality of insulating layers with a conductive material.

The through hole may be formed by any one of mechanical, laser, and chemical processing. When the through-hole is formed by mechanical processing, a method such as milling, drilling and routing may be used, when the through-hole is formed by laser processing, a method of UV or CO₂ laser may be used, when the through-hole is formed by chemical processing, a chemical including amino silane, ketones, or the like may be used, so that at least one insulating layer among the plurality of insulating layers may be opened.

Meanwhile, the laser processing is a cutting method in which a part of a material is melted and evaporated by concentrating optical energy at a surface to take a desired shape. Complex formation by a computer program may be easily processed, and composite materials which are difficult to cut by other methods may be processed.

In addition, the laser processing may have a cutting diameter of at least 0.005 mm, and have a wide range of thickness that may be processed.

It is preferable to use an yttrium aluminum garnet (YAG) laser or CO₂ laser or ultraviolet (UV) laser as the laser processing drill. The YAG laser is a laser capable of processing both a copper foil layer and an insulation layer, and the CO₂ laser is a laser capable of processing only an insulation layer.

When the through hole is formed, the through parts may be formed by filling the inside of the through-hole with a conductive material. The metal material forming the through parts may be any one selected from among copper (Cu), silver (Ag), tin (Sn), gold (Au), nickel (Ni), and palladium (Pd), and the conductive material may be filled by any one of electroless plating, electroplating, screen printing, sputtering, evaporation, ink jetting, and dispensing, or a combination thereof.

Meanwhile, the circuit board 100 may further include a protective layer 140. The protective layer 140 may be selectively formed on a lowermost side of the circuit board 100.

The protective layer 140 may be a solder resist. The protective layer 140 may include at least one opening exposing a surface of the pad.

In this case, the embodiment may allow the protective layer 140 to be provided only on the lowermost side of the circuit board 100. Specifically, a protective layer may not be provided on the upper surface of the circuit board 100. For example, a solder resist may not be disposed on the first surface of the fifth insulating layer 115, which is the first outermost insulating layer according to the embodiment. In addition, the protective layer 140 corresponding to the solder resist may be formed only on the second surface of the eighth insulating layer 118, which is the second outermost insulating layer of the embodiment.

The embodiment includes an outer through electrode exposed to an outer side surface of the circuit board. Accordingly, the embodiment may allow heat generated through the chip to be transferred to a side surface of the circuit board through the outer through electrode, thereby improving the heat dissipation performance of the circuit board.

In addition, the embodiment may allow at least one insulating layer among the plurality of insulating layers not to be provided with an outer through electrode. For example, an plurality of outer through electrodes included in the circuit board are divided into a plurality of groups, and accordingly, the heat may be discharged through paths separated from each other. As described above, the embodiment allows at least one layer of insulating layer in which an outer through electrode is not disposed, so that heat generated in a chip is diverged and transferred through the outer through electrodes separated from each other. Accordingly, the embodiment may further improve heat dissipation performance.

In addition, the embodiment allows the inner through electrode disposed adjacent to the chip to have a large area in the shape of a bar extending in a longitudinal direction. Accordingly, the embodiment can efficiently transfer heat generated from the chip to the outer through electrode, thereby further improving heat dissipation performance.

In addition, the embodiment allows each outer through electrode to include a plurality of sub through electrodes (or through electrode parts) spaced apart in the second direction, so that the heat can be dissipated from a single outer through electrode through a plurality of branched paths, thereby further improving heat dissipation performance and improving product reliability.

In addition, the embodiment allows each outer through electrode to have a ' U ' shape or a '□' shape. Accordingly, when dissipating heat from each outer through electrode to a separation line through the plurality of sub through electrodes as described above, the embodiment can effectively prevent heat from being intensively dissipated to a specific sub-through electrode, thereby further improving heat dissipation characteristics.

In addition, the embodiment allows each outer through electrode to be exposed to different side surfaces of the circuit board. For example, the first outer through electrode of the embodiment may be exposed to a first side surface of the circuit board, and the second outer through electrode may be exposed to the second side surface opposite to the first side surface of the circuit board. Accordingly, the embodiment can further improve heat dissipation performance compared to dissipating heat only in one direction, and thereby improve product reliability.

Hereinafter, a method of manufacturing the circuit board shown in FIGS. 1 and 2 will be described. The circuit board may be manufactured in a strip unit.

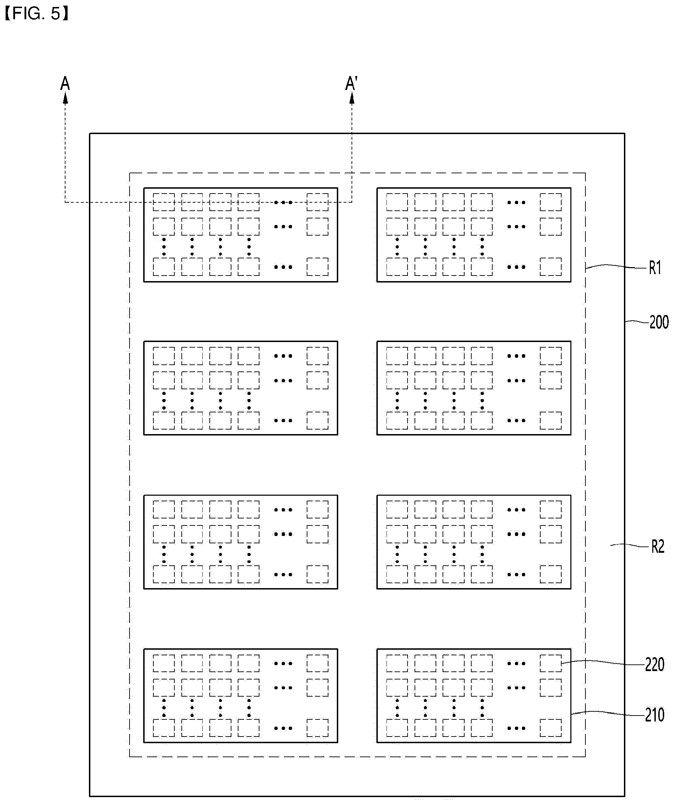

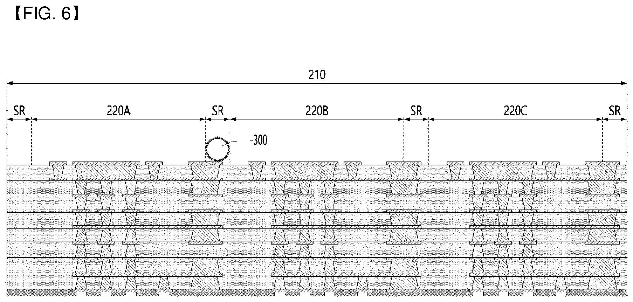

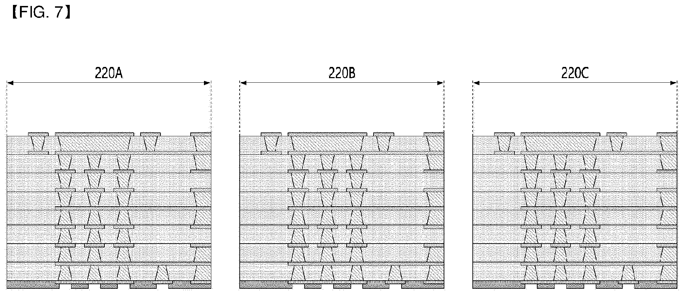

FIG. 5 is a schematic plan view of a circuit board panel according to an embodiment, and FIGS. 6 and 7 are views for explaining circuit boards manufactured in a strip unit.

Referring to FIGS. 5 to 7, the circuit board panel 200 may be a copper clad laminate (CCL) panel, but is not limited thereto. The circuit board panel 200 may have a certain size. For example, a width of the circuit board panel 200 in a first direction may have a range of 415 mm to 430 mm, and a width in a second direction may have a range of 510 mm to 550 mm, but is not limited thereto.

Here, the first direction may mean a horizontal direction of the circuit board panel 200. Also, the first direction may refer to a direction of a minor axis of the circuit board panel 200. In addition, the second direction may mean a vertical direction of the circuit board panel 200. Also, the second direction may mean a major axis direction of the circuit board panel 200.

The circuit board panel 200 may be divided into a plurality of strips 210. The plurality of strips 210 may be spaced apart from each other in the first and second directions within the circuit board panel 200. For example, the circuit board panel 200 may be divided into regions corresponding to the plurality of strips 210. For example, the circuit board panel 200 may be partitioned into a plurality of regions in the first direction and the second direction, respectively. In addition, the strip 210 may be positioned in each of the partitioned regions.

For example, as shown in FIG. 3, the circuit board panel 200 may be partitioned into eight regions, and the strip 210 may be positioned in each of the eight partitioned regions. That is, the circuit board panel 200 in the embodiment may be composed of eight strips 210. However, the number of strips 210 included in the circuit board panel 200 is not limited thereto.

Meanwhile, when the circuit board panel 200 includes eight strips 210, the circuit board panel 200 is partitioned into two regions in a first direction and four regions in the second direction.

The strip 210 may include a plurality of units 220. For example, one strip 210 may include 1,275 units 220, but is not limited thereto. That is, the circuit board panel 200 in the embodiment includes a plurality of strips 210, and each of the plurality of strips 210 includes a plurality of units 220. In addition, each of the plurality of units 220 may constitute one circuit board. In this case, each of the plurality of units 220 included in the strip 210 may have a width of 3 mm in a first direction and a width of 2 mm in a second direction, but is not limited thereto.

That is, the strip 210 may include a plurality of units 220 spaced apart from each other in the first and second directions. In this case, the number of units 220 disposed in the first direction within the strip 210 may be greater than the number of units 220 disposed in the second direction. In addition, a width of the unit 220 in the first direction within the strip 210 may be greater than a width of the unit 220 in the second direction.

The circuit board panel 200 as described above may include an effective region R1 where the strip 210 and the units 220 are provided and a dummy region R2 other than the effective region R1. The dummy region R2 may be an outer region of the effective region R1. For example, the dummy region R2 may be an edge region of the circuit board panel 200.

The strip 210 and the unit 220 may be positioned in the effective region R1 of the circuit board panel 200. For example, the circuit board may be positioned in the effective region R1 of the circuit board panel 200. That is, the circuit board shown in FIG. 1 may be formed in the effective region R1.

In addition, in a process of manufacturing the strip 210 and further the unit 220 formed in the effective region R1, components for increasing reliability or securing lot traceability may be positioned in the dummy region R2 of the circuit board panel 200. For example, a dummy pattern (not shown) may be provided in the dummy region R2 of the circuit board panel 200, so that the dummy pattern suppresses warping of the circuit board corresponding to the unit 220 in the effective region R1 or improves the thickness uniformity of the circuit pattern.

Meanwhile, as shown in FIG. 6, the circuit board panel 200 as described above may be manufactured in a strip unit. For example, a plurality of units 210, for example, a circuit board, may be positioned in the strip 210.

Accordingly, the strip 210 may include a first unit region 220A, a second unit region 220B, and a third unit region 220C. And, a sawing region (SR: sawing region) may be positioned between each unit region. The sawing region may be a working position of a separation member 300 for separating each unit region from each other.

At this time, a sawing through part corresponding to the outer through electrode of the embodiment may be formed in the sawing region SR. In addition, the sawing region may be aligned with the sawing through part in the thickness direction. Accordingly, the separating member 300 performs sawing at a position corresponding to the sawing through part, and accordingly, outer through electrodes included in the circuit board of the embodiment may be exposed through the side of the circuit board as shown in FIG. 7.

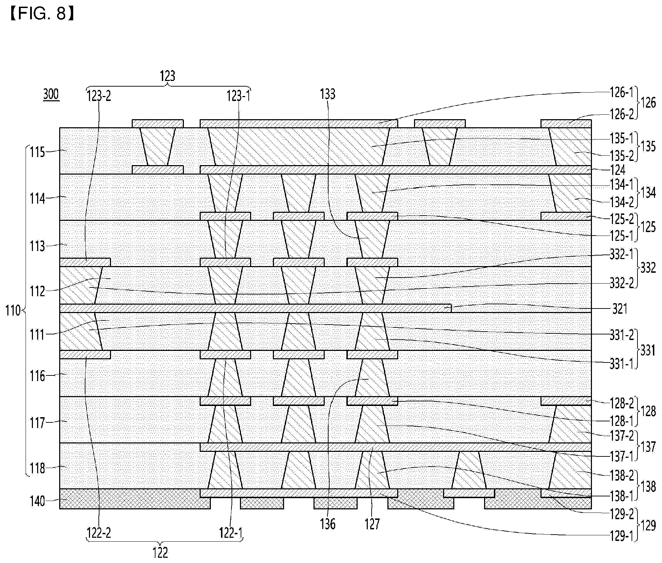

FIG. 8 is a view illustrating a circuit board according to a second embodiment.

A circuit board 300 shown in FIG. 8 is substantially similar to the circuit board 100 shown in FIG. 1, and the position where the outer through electrode is formed may be different.

For example, the circuit board 300 includes a first through part 331 and a second through part 332.

The first through part 331 may include a first-first through electrode 331-1 and a first-second through electrode 331-2 according to an arrangement position. The first-first through electrode 331-1 may be disposed inside the first insulating layer 111. The number of first-first through electrodes 331-1 may be provided in plurality. For example, a plurality of first-first through electrodes 331-1 may be disposed inside the first insulating layer 111 and spaced apart from each other in a first direction (or longitudinal direction or horizontal direction). A first surface of each of the plurality of first-first through electrodes 331-1 may be commonly connected to the first pad 321.

In addition, each second surface of the plurality of first-first through electrodes 331-1 may be individually connected to the second-first pad 122-1. For example, a plurality of second-first pads 122-1 may be disposed on the second surface of the first insulating layer 111 and spaced apart from each other in the first direction. In addition, the second surfaces of each of the plurality of first-first through electrodes 331-1 may be respectively connected to the plurality of second-first through electrodes 122-1. The first-second through electrode 331-2 may be disposed outside the first insulating layer 111. Here, being disposed outside may mean that the outer side surface of the first-second through electrode 331-2 is exposed through the outer side surface of the first insulating layer 111.

An outer side surface of the first-second through electrode 331-2 may be positioned on the same plane as an outer side surface of the first insulating layer 111. For example, the first-second through electrode 331-2 may be positioned on the same line as the outer side surface of the first insulating layer 111 and the outer side surface of the circuit board 300, so that the first-second through electrode 331-2 may be exposed to the outside.

A first surface of the first-second through electrode 331-2 may be connected to the first pad 321.

Meanwhile, the first-first through electrode 331-1 may have a shape different from a shape of the first-second through electrode 331-2. For example, first side and the second side of the first-first through electrode 331-1 may include an inclined surface. For example, a first side of the first-second through electrode 331-2 may include an inclined surface and a second side of the first-second through electrode 331-2 may include a vertical surface. For example, the second side surface of the first-second through electrode 331-2 may be perpendicular to the first surface or the second surface of the first insulating layer 311.

The second through part 332 may include a second-first through electrode 332-1 and a second-second through electrode 332-2 according to an arrangement position. The second-first through electrode 332-1 may be disposed inside the second insulating layer 112. The number of second-first through electrodes 332-1 may be provided in plurality. For example, a plurality of second-first through electrodes 332-1 may be disposed inside the second insulating layer 112 and spaced apart from each other in a first direction (or longitudinal direction or horizontal direction). The second surfaces of each of the plurality of second-first through electrodes 332-1 may be commonly connected to the first pad 321.

The second-second through electrode 332-2 may be disposed outside the second insulating layer 112. Here, being disposed outside may mean that the outer side surface of the second through electrode 332-2 is exposed through the outer side surface of the second insulating layer 112.

An outer side surface of the second through electrode 332-2 may be positioned on the same plane as an outer side surface of the second insulating layer 112. For example, the second-second through electrode 332-2 may be positioned on the same line as the outer side surface of the second insulating layer 112 and the outer side surface of the circuit board 300, so that the second-second through electrode 332-2 may be exposed to the outside.

In this case, one side surfaces of the first-second through electrode 331-2 and the second-second through electrode 332-2 may be exposed through a first outer side surface of the circuit board. In this case, the first outer side surface may be a left side surface of the circuit board.

That is, the first-second through electrode 331-2 and the second-second through electrode 332-2 may form a first outer through electrode group. Accordingly, the first outer through electrode group may provide a first heat transfer path through which heat generated in the chip is dissipated. In this case, the first heat transfer path may be provided at a left side surface of the circuit board.

In addition, a second outer through electrode group or a third outer through electrode group spaced apart from the first outer through electrode group may dissipate heat in a direction different from that of the first outer through electrode group. In detail, the second outer through electrode group including the fourth-second through electrode 134-2 and the fifth-second through electrode 135-2, or the third outer through electrode group including seventh-second through electrode 137-2 and eighth-second through electrode 138-2 may dissipate heat in a direction different from that of the first outer through electrode group. For example, the second outer through electrode group or the third outer through electrode group may be exposed through a second side surface of the circuit board. For example, the second outer through electrode group or the third outer through electrode group may be exposed on a right side surface opposite to a left side surface of the circuit board.

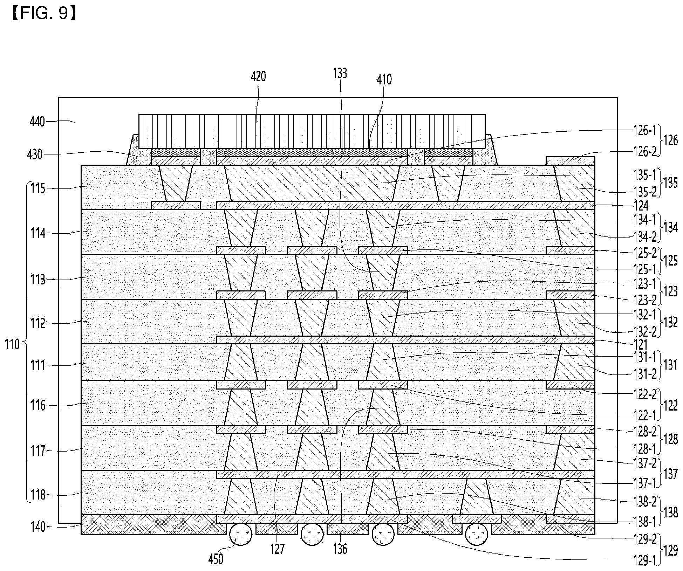

FIG. 9 is a view illustrating a semiconductor package according to an embodiment.

Referring to FIG. 9, the package substrate includes the circuit board shown in at least one of FIGS. 1 and 8. Hereinafter, a package substrate including the circuit board shown in FIG. 1 will be described for convenience of description. However, the embodiment is not limited thereto, and the package substrate described below may include the circuit board shown in FIG. 8.

In addition, the package substrate includes an adhesive member disposed on the pad of the circuit board.

Specifically, the package substrate may include a first adhesive member 410 disposed on the sixth-first pad 126-1 provided at an uppermost side. In addition, the package substrate may include a second adhesive member 450 disposed on the ninth-first pad 129-1 provided at a lowermost side of the circuit board.

The first adhesive member 410 and the second adhesive member 450 may have a different shape. For example, the first adhesive member 410 may have a hexahedral shape. For example, a cross section of the first adhesive member 410 may have a rectangular shape. For example, the cross section of the first adhesive member 410 may include a rectangular or square shape. The second adhesive member 450 may have a spherical shape. For example, a cross section of the second adhesive member 450 may include a circular shape or a semicircular shape. For example, the cross section of the second adhesive member 450 may have a partially or entirely rounded shape. For example, the cross sectional shape of the second adhesive member 450 may include a flat surface on one side and a curved surface on the other side opposite to the one side. Meanwhile, the second adhesive member 450 may be a solder ball, but is not limited thereto.

A chip 420 may be mounted on the first adhesive member 410. A chip 420 may be mounted on the first adhesive member 320. For example, the chip 420 may include a drive IC chip. For example, the chip 420 may mean various chips including sockets or devices other than a drive IC chip. For example, the chip 420 may include at least one of a diode chip, a power IC chip, a touch sensor IC chip, an MLCC chip, a BGA chip, and a chip capacitor. For example, the chip 420 may be a power management integrated circuit (PMIC). For example, the chip 420 may be a memory chip such as a volatile memory (e.g. DRAM), a non-volatile memory (e.g. ROM), or a flash memory. For example, the chip 420 may be an application processor (AP) chip such as a central processor (e.g., CPU), a graphic processor (e.g., GPUs), a digital signal processor, a cryptographic processor, a microprocessor, and microcontroller, etc., or a logic chip such as an analog-to-digital converter or an application-specific IC (ASIC). Here, it is illustrated that only one chip is mounted in a semiconductor package in the drawings, but it is not limited thereto. The semiconductor package may include a plurality of chips, and the plurality of chips may include a first AP chip corresponding to a central processor (CPU) and a second AP chip corresponding to a graphic processor (GPU).

Meanwhile, the package substrate includes a fillet layer 430. The fillet layer 430 may be formed to surround a pad disposed on an uppermost side of the circuit board, the first adhesive member 410 and a part of the chip 420. The fillet layer 430 may be selectively formed to improve mounting performance of the chip 420 while preventing foreign substances from entering the chip 420.

A molding layer 440 may be formed on the circuit board. The molding layer 440 may be disposed to cover the mounted chip 420. For example, the molding layer 440 may be an EMC (Epoxy Mold Compound) formed to protect the mounted chip 420, but is not limited thereto.

The molding layer 440 may directly contact the first surface of the fifth insulating layer 115 disposed on the uppermost side of the insulating layers 110 of the circuit board. Here, the first surface of the fifth insulating layer 115 may be an upper surface of the fifth insulating layer 115. For example, in the embodiment, a solder resist is not provided on the upper surface of the fifth insulating layer 115, and thus the upper surface of the fifth insulating layer 115 may directly contact the molding layer 440.

Meanwhile, the molding layer 440 may be formed surrounding the side surface of the circuit board 100. Accordingly, the molding layer 440 may be formed to cover outer through electrodes exposed on the side surface of the circuit board 100. For example, the outer through electrodes exposed through a side surface of the circuit board 100 may directly contact the molding layer 440.

As described above, the molding layer 440 is disposed not only on an upper portion of the circuit board 100 but also on the side portion of the circuit board 100. Accordingly, in the case of a structure in which the molding layer 440 surrounds the side portion of the circuit board, the heat dissipation of the chip 420 is greatly reduced. At this time, the embodiment allows the outer through electrodes of the circuit board to be exposed through the side surface of the circuit board as described above, so that the heat is dissipated to the molding layer 440, and thereby improving heat dissipation.

In this case, the molding layer 440 may have a low dielectric constant in order to increase heat dissipation characteristics. For example, the dielectric constant (Dk) of the molding layer 440 may be 0.2 to 10. For example, the dielectric constant (Dk) of the molding layer 440 may be 0.5 to 8. For example, the dielectric constant (Dk) of the molding layer 440 may be 0.8 to 5. Accordingly, the embodiment allows the molding layer 440 to have a low dielectric constant, so that heat dissipation characteristics can be further improved through combination with the outer through electrodes.

Meanwhile, the package substrate according to the embodiment may have a structure including a first insulating layer and a second insulating layer of the circuit board. In this case, the first adhesive member 410 may be disposed on the third-first pad, and the second adhesive member 450 may be disposed on the second-first pad. In addition, a protective layer of the circuit board may be disposed on a second surface of the first insulating layer, and a molding layer 440 may be disposed on the first surface of the second insulating layer without a protective layer.

The characteristics, structures, effects, and the like described in the above-described embodiments are included in at least one embodiment, but are not limited to only one embodiment. Furthermore, the characteristic, structure, and effect illustrated in each embodiment may be combined or modified for other embodiments by a person skilled in the art. Therefore, it should be construed that contents related to such combination and modification are included in the scope of the embodiment.

Embodiments are mostly described above, but the embodiments are merely examples and do not limit the embodiments, and a person skilled in the art may appreciate that several variations and applications not presented above may be made without departing from the essential characteristic of embodiments. For example, each component specifically represented in the embodiments may be varied. In addition, it should be construed that differences related to such a variation and such an application are included in the scope of the embodiment defined in the following claims.

## Claims

1. A semiconductor package comprising:
a first insulating layer;
a first pad disposed on a first surface of the first insulating layer;
a second pad disposed on a second surface of the first insulating layer opposite to the first surface; and
a first through part passing through the first insulating layer,
wherein the first through part comprises:
a first-first through electrode disposed in a first region of the first insulating layer; and
a first-second through electrode disposed in a second region of the first insulating layer,
wherein the second region is adjacent to an outer side surface of the first insulating layer,
wherein an outer side surface of the first-second through electrode is positioned on the same plane as the outer side surface of the first insulating layer, and
wherein the first pad extends from the first region of the first insulating layer to the second region to connect the first-first through electrode and the first-second through electrode.

2. The semiconductor package of claim 1, wherein a width of the first-second through electrode has a range of 0.3 times and 2 times a width of the first-first through electrode.

3. The semiconductor package of claim 1, wherein one first pad connects between an upper surface of the first-first through electrode and an upper surface of the first-second through electrode, and
wherein the second pad comprises:
a second-first pad disposed in the first region of the first insulating layer and connected to a lower surface of the first-first through electrode; and
a second-second pad disposed in the second region of the first insulating layer and connected to a lower surface of the first-second through electrode.

4. The semiconductor package of claim 3, wherein an outer side surface of the first pad, an outer side surface of the second-second pad, the outer side surface of the first-second through electrode, and the outer side surface of the first insulating layer are positioned on the same plane.

5. The semiconductor package of claim 1, wherein the first-first through electrode has a shape different from a shape of the first-second through electrode.

6. The semiconductor package of claim 5, wherein the outer side surface of the first-second through electrode is perpendicular to the first surface of the first insulating layer.

7. The semiconductor package of claim 6, wherein an inner side surface of the first-second through electrode has an inclination with respect to the first surface of the first insulating layer.

8. The semiconductor package of claim 1, wherein at least one of the first-first through electrode and the first-second through electrode has a bar shape extending in a longitudinal direction.

9. The semiconductor package of claim 1, wherein the first-second through electrode includes a plurality of sub through electrodes including an outer side surface respectively positioned on the same plane as the outer side surface of the first insulating layer and spaced apart from each other.

10. The semiconductor package of claim 9, wherein the first-second through electrode includes a connection through electrode connecting the plurality of sub through electrodes, and
wherein a planar shape of the first-second through electrode has a U-shape.
